(19) Europäisches Patentamt
European Patent Office
Office européen des brevets

(11) **EP 4 253 976 A1**

(12) **EUROPÄISCHE PATENTANMELDUNG**

(43) Veröffentlichungstag:
**04.10.2023 Patentblatt 2023/40**

(21) Anmeldenummer: **22164891.8**

(22) Anmeldetag: **29.03.2022**

(51) Internationale Patentklassifikation (IPC):
**G01R 33/24** (2006.01)    **G01R 33/565** (2006.01)

(52) Gemeinsame Patentklassifikation (CPC):
**G01R 33/243; G01R 33/56518;** G01R 33/56572

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder: **Köhler, Michael**
**90408 Nürnberg (DE)**

Bemerkungen:
Geänderte Patentansprüche gemäss Regel 137(2) EPÜ.

(54) **VERMESSUNG EINES GRADIENTENFELDS IN EINEM MRT-SYSTEM**

(57)    Gemäß einem Verfahren zur Vermessung eines Gradientenfeldes in einem MRT-System (1) wird eine erste Schicht (17a) angeregt, indem ein erster HF-Impuls (13a, 13b, 13c) emittiert wird und ein erster Schichtselektionsgradient (14a, 14b, 14c) wenigstens zum Teil gleichzeitig mit dem ersten HF-Impuls (13a, 13b, 13c) geschaltet wird. Eine zweite Schicht (18a) wird angeregt, indem ein zweiter HF-Impuls (13a, 13b, 13c) in emittiert wird und ein zweiter Schichtselektionsgradient (14a, 14b, 14c) wenigstens zum Teil gleichzeitig mit dem zweiten HF-Impuls (13a, 13b, 13c) geschaltet wird, wobei die zweite Schicht (18a) die erste Schicht (17a) in einem Schnittbereich (19a) schneidet. Nach der Anregung der zweiten Schicht (18a) wird ein Auslesegradient (15) geschaltet und ein aus dem Schnittbereich (19a) emittiertes MR-Signal wird erfasst. Abhängig von dem MR-Signal wird eine Störgröße berechnet, die eine Abweichung eines zeitlichen Verlaufs einer Amplitude des Auslesegradienten (15) von einem vorgegebenen Sollverlauf bestimmt.

FIG 3

**Beschreibung**

Die vorliegende Erfindung betrifft Verfahren zur Vermessung eines Gradientenfelds in einem Bildgebungsbereich eines MRT-Systems, wobei eine erste Schicht in einem Testobjekt, das sich in dem Bildgebungsbereich befindet, angeregt wird, indem ein erster HF-Impuls in den Bildgebungsbereich emittiert wird und ein erster Schichtselektionsgradient wenigstens zum Teil gleichzeitig mit dem ersten HF-Impuls geschaltet wird. Die Erfindung betrifft ferner ein entsprechendes MRT-System.

Vorrichtungen zur Magnetresonanztomographie, MRT, sind bildgebende Vorrichtungen, die ein starkes äußeres Magnetfeld nutzen, um die Kernspins eines zu untersuchenden Objekts auszurichten und sie durch Anlegen eines HF-Anregungspulses zur Präzession um die entsprechende Ausrichtung anzuregen. Die Präzession beziehungsweise der Übergang der Spins von diesem angeregten Zustand in einen Zustand mit geringerer Energie erzeugt als Antwort ein elektromagnetisches Wechselfeld, das über Empfangsantennen als MR-Signal detektiert werden kann.

Mit Hilfe von magnetischen Gradientenfeldern kann den Signalen eine Positionskodierung aufgeprägt werden, die es anschließend erlaubt, das erhaltene Signal einem Volumenelement des Untersuchungsobjekts zuzuordnen. Das empfangene Signal kann dann ausgewertet werden, um beispielsweise eine Bilddarstellung des Untersuchungsobjekts bereitzustellen.

Abweichungen des zeitlichen Verlaufs der Gradientenfelder, auch als Gradiententrajektorien bezeichnet, von entsprechenden Sollvorgaben können durch Wirbelströme, Nichtlinearitäten, Reglerabweichungen eines Gradientenverstärkers oder sonstige Übertragungseffekte, beispielsweise Filtercharakteristiken der verwendeten Hardware, verursacht werden. Besonders relevant sind Wirbelströme, die zu einer ortsabhängigen Beeinflussung der erzeugten Gradientenfelder führen können. Insbesondere Wirbelströme mit relativ kurzen Zeitkonstanten, etwa im Bereich von wenigen ms und oder weniger, sind besonders relevant.

Durch die Abweichungen oder Imperfektionen des zeitlichen Verlaufs der Gradientenfelder kann zum Beispiel die Ortskodierung bei der MR-Bildgebung beeinflusst werden. Besonders kann es durch Verfälschungen des Auslesegradienten zu Artefakten kommen, da die beabsichtigte Gradiententrajektorie nicht genau realisiert wird und die aufgenommenen Daten dadurch falsch in den k-Raum einsortiert werden. Je nach verwendeter Sequenztechnik können dadurch verschiedene Artefakte entstehen.

Insbesondere sind diese Effekte relevant bei MR-Sequenzen, die für die Aufnahme von Zeilen im k-Raum Auslesegradienten mit veränderlicher Amplitude und/oder Polarität verwenden. Hierzu zählen unter anderem Sequenzen der echoplanaren Bildgebung, EPI (englisch: "echo planar imaging"), der spiralen Bildgebung, Messungen mit sinusförmigen Auslesegradienten oder radiale Aufnahmetechniken.

Typische resultierende Artefakte sind das sogenannte Nyquist-Ghosting oder N/2-Ghosting bei EPI-Messungen. Dies geht darauf zurück, dass bei EPI verschiedene Polaritäten des Auslesegradienten für verschiedene k-Raum-Zeilen verwendet werden. Die oben erwähnten Abweichungen der tatsächlichen Gradientenform von der beabsichtigten führen dazu, dass nun die Zeilen im k-Raum, die mit positiver Gradientenpolarität aufgenommen werden, eine andere Störung, zum Beispiel durch Verschiebung des Echos oder akkumulierte Phasen, erfahren als die mit negativer Polarität gemessenen Zeilen im k-Raum.

Zudem ist die Problematik besonders relevant bei Messungen mit Datenakquisition während einer sogenannten Gradiententenrampe (englisch: "ramp sampling"). Um übliche FFT-Techniken zur Transformation der k-Raum-Daten in den Bildraum anzuwenden, werden die Daten, die während der Gradiententenrampe aufgenommen werden und damit einer nicht äquidistanten k-Raum-Abtastung entsprechen, üblicherweise zunächst in äquidistante Punkte im k-Raum konvertiert. Dieser Vorgang wird auch als Gridding oder Re-Gridding bezeichnet. Zur korrekten Einordnung der Daten in den k-Raum ist dabei die Kenntnis des zeitlichen Verlaufs des ausgespielten Auslesegradienten wichtig. Die erwähnten Abweichungen können zu einem inkorrekten Gridding führen, was Artefakte verursachen kann, wie sogenanntes "Ringing" in Auslese-Richtung und "Ghosting" bei EPI-Messung mit ramp sampling. Letzteres betrifft vor allem eine Art von Ghosting, bei dem Kanten des Objektes als besonders starker Geist in Erscheinung treten.

Wirbelströme können verschiedene räumliche Verteilungen von Feldstörungen bewirken. Sie können beispielsweise eingeteilt werden in B0-artige Wirbelströme, welche eine räumlich konstante Feldstörung erzeugen, lineare beziehungsweise gradientenartige Wirbelströme, welche eine gradientenartige Feldstörung erzeugen, die im Wesentlichen den gleichen räumlichen Verlauf wie der sie erzeugende Gradient aufweist, Kreuzterme und Wirbelströme höherer räumlicher Ordnung. Kreuzterme erzeugen eine gradientenartige Feldstörung, die jedoch einen Verlauf aufweisen, der orthogonal zu dem sie erzeugenden Gradienten verläuft, zum Beispiel wenn ein Gradient in X-Richtung einen Wirbelstrom erzeugt, der zu einem Feld führt, das linear in Y-Richtung verläuft. Wirbelströme höherer räumlicher Ordnung erzeugen Feldstörungen, deren Verlauf von mehr als einer räumlichen Koordinate oder von einer Potenz einer Koordinate abhängen.

Alle diese Arten von Wirbelströmen können die oben erwähnten Probleme verursachen. Dem kann beispielsweise durch eine Wirbelstromkompensation, ECC (englisch: "eddy current compensation") durch Pre-Emphasis bei der Ausspielung von Gradientenimpulsen entgegengewirkt werden, wie etwa im Dokument US 5,451,877 A beschrieben.

Außerdem ist es möglich, die Abweichung der Gradientenfelder beim Gridding nachträglich zu berücksichtigen.

In beiden Fällen ist es jedoch erforderlich, die Abweichung des zeitlichen Verlaufs der Gradientenfelder zu vermessen. Dokument US 2016/0091582 A1 beschreibt ein Verfahren, bei dem die zeitlichen Schwankungen des Magnetfelds in einem MRTvolumen auf der Grundlage der Steigung einer Phasendifferenz zwischen den Spinantworten in mehreren Schichten bestimmt werden. Diese werden gespeichert und zum exakteren Re-Gridding der erfassten k-Raum-Daten vor der Bildrekonstruktion verwendet.

Ein Nachteil dabei ist, dass durch inhärente Mittelungen Feldstörungen höherer räumlicher Ordnung nicht oder nicht vollständig abgebildet werden.

Um dem zu begegnen können spezielle Sensoren, die auch als Feldsonden (englisch: "field probes") oder Feldkameras bezeichnet werden, eingesetzt werden, um die Feldverteilung dreidimensional aufgelöst zu bestimmen. Solche Ansätze erfordern jedoch üblicherweise eine aufwändige Kalibrierung des Systems unabhängig von klinischen Messungen und auch deren Integration in die Datennahme und Datenaufbereitung ist aufwändig.

Es ist eine Aufgabe der vorliegenden Erfindung, Störeinflüsse, insbesondere Störfelder, die den zeitlichen Verlauf von Gradientenfeldern bei der Magnetresonanzbildgebung beeinflussen, in räumlicher Hinsicht genauer zu bestimmen, insbesondere Störungen höherer räumlicher Ordnung genauer zu bestimmen.

Diese Aufgabe wird gelöst durch den jeweiligen Gegenstand der unabhängigen Ansprüche. Vorteilhafte Weiterbildungen und bevorzugte Ausführungsformen sind Gegenstand der abhängigen Ansprüche.

Die Erfindung beruht auf dem Gedanken, zwei voneinander verschiedene und sich in einem Testobjekt schneidende Schichten anzuregen, danach einen Auslesegradienten zu schalten und ein aus einem entsprechenden Schnittbereich der Schichten emittiertes MR-Signal zu erfassen. Abhängig von dem MR-Signal wird eine Störgröße berechnet, die die Abweichung des zeitlichen Verlaufs der Amplitude des Auslesegradienten von einem vorgegebenen Sollverlauf bestimmt.

Gemäß einem Aspekt der Erfindung wird ein Verfahren zur Vermessung eines Gradientenfelds in einem Bildgebungsbereich eines MRT-Systems angegeben. Dabei wird eine erste Schicht in einem Testobjekt, das sich in dem Bildgebungsbereich befindet, angeregt, insbesondere mittels einer HF-Sendespulenanordnung und einer Gradientenspulenanordnung des MRT-Systems, die insbesondere durch wenigstens eine Steuereinheit des MRT-Systems angesteuert werden, um die erste Schicht anzuregen. Nach der Anregung der ersten Schicht wird eine zweite Schicht in dem Testobjekt angeregt, insbesondere mittels der Gradientenspulenanordnung und der HF-Sendespulenanordnung angesteuert durch die wenigstens eine Steuereinheit, wobei die zweite Schicht die erste Schicht innerhalb des Testobjekts in einem Schnittbereich schneidet. Nach der Anregung der zweiten Schicht wird ein Auslesegradient geschaltet, der auch als Testgradient bezeichnet werden kann, insbesondere mittels der Gradientenspulenanordnung angesteuert durch die wenigstens eine Steuereinheit, und ein aus dem Schnittbereich emittiertes MR-Signal erfasst, insbesondere mittels einer Signalerfassungsvorrichtung des MRT-Systems. Abhängig von dem MR-Signal wird eine Störgröße berechnet, insbesondere mittels einer Recheneinheit des MRT-Systems, wobei die Störgröße eine Abweichung eines zeitlichen Verlaufs einer Amplitude des Auslesegradienten von einem vorgegebenen Sollverlauf für den Auslesegradienten, insbesondere für die Amplitude des Auslesegradienten, bestimmt.

Die Begriffe eines Gradienten, insbesondere eines Auslesegradienten, eines Schichtselektionsgradiente und so weitere, und eines Gradientenfeldes werden hier und im Folgenden in der im Kontext der MR-Bildgebung gebräuchlichen Weise verwendet. Zum Schalten eines Gradienten, insbesondere des Auslesegradienten, wird also insbesondere ein entsprechendes räumlich veränderliches Magnetfeld mittels der Gradientenspulenanordnung erzeugt. Die Änderung der Amplitude des Magnetfelds als Funktion der räumlichen Koordinaten entspricht dann einem Gradienten oder Gradientenfeld in der verwendeten Bedeutung. Ein zeitlicher Verlauf der Amplitude des Gradienten oder mehrerer Amplituden von Gradienten in verschiedene Richtungen kann auch als Gradiententrajektorie bezeichnet werden.

Bei dem Testobjekt kann es sich je nach Ausführungsform des erfindungsgemäßen Verfahrens um ein abzubildendes Objekt handeln, insbesondere um einen Patienten, das während einer MRT-Bildgebung, die beispielsweise auf das erfindungsgemäße Verfahren zur Vermessung des Gradientenfelds folgen kann, abgebildet werden soll. Es kann sich jedoch auch um ein sogenanntes Phantomobjekt handeln, das beispielsweise bei der Kalibrierung oder beim sogenannten Tune-up eines MRT-Systems eingesetzt wird.

Das Schalten eines Gradienten, insbesondere des Auslesegradienten, kann als zeitabhängige Aktivierung und Deaktivierung beziehungsweise Steuerung der Gradientenspulenanordnung verstanden werden, um einen entsprechenden zeitlichen Verlauf des Gradientenfeldes zu erzeugen. Ein Gradient kann dabei auch als Gradientenimpuls mit einem oder mehreren Teilen, die auch als Lobes bezeichnet werden, verstanden werden.

Die erste und die zweite Schicht sind voneinander verschieden und nicht parallel zueinander, sodass sie sich innerhalb des Testobjekts schneiden. Bei jeder Schicht handelt es sich näherungsweise um einen dreidimensionalen räumlichen Bereich mit konstanter Dicke, die auch als Schichtdicke bezeichnet wird. Dementsprechend ist ein Volumenbereich, in dem sich die erste und die zweite Schicht schneiden, abgesehen von Abweichungen durch die Form des Testobjekts, näherungsweise durch ein dreidimensionales Volumen in Form einer Säule gegeben. Stehen die erste und die zweite Schicht senkrecht aufeinander, so hat die Säule näherungsweise einen rechteckigen oder quadratischen Querschnitt.

Der Schnittbereich kann der gesamten Säule entsprechen oder einem Teil davon. Insbesondere ist es in verschiedenen Ausführungsformen des Verfahrens möglich, dass nur die erste Schicht und die zweite Schicht angeregt werden, jedoch keine weitere Schicht. Dann entspricht der Schnittbereich der gesamten Säule, also dem gesamten Volumenbereich, in dem sich die erste und die zweite Schicht schneiden. Es ist jedoch auch möglich, dass eine dritte Schicht angeregt wird, die sowohl die erste Schicht als auch die zweite Schicht schneidet. In diesem Fall kann es sich bei dem Schnittbereich um einen Teil der Säule handeln. Wenn die erste, die zweite und die dritte Schicht jeweils senkrecht aufeinander stehen, handelt es sich beispielsweise um einen quaderförmigen oder würfelförmigen Teil der Säule.

Bei dem Schnittbereich handelt es sich also stets um einen Volumenbereich, der in allen involvierten angeregten Schichten enthalten ist. Dementsprechend wird das MR-Signal auch aus dem Schnittbereich emittiert. Mit anderen Worten, durch die Anregung der ersten Schicht und der zweiten Schicht sowie optional der dritten Schicht wird erreicht, dass beim Schalten des Auslesegradienten und/oder nach dem Schalten des Auslesegradienten das MR-Signal erfasst wird, welches aus dem Schnittbereich emittiert wird.

Bei dem MR-Signal handelt es sich um ein Signal aufgrund einer resonanten Spinantwort der angeregten Kernspins in dem Schnittbereich. Je nach Ausführungsform des Verfahrens kann es sich dabei um ein sogenanntes Spinecho oder ein sogenanntes stimuliertes Echo handeln. Insbesondere handelt es sich um ein Spinecho, wenn lediglich die erste und die zweite Schicht angeregt werden, nicht aber die dritte Schicht, wohingegen es sich um ein stimuliertes Echo handelt, wenn die erste Schicht, die zweite Schicht und die dritte Schicht angeregt werden.

Das Erfassen des MR-Signals beinhaltet insbesondere das Erzeugen von entsprechenden MR-Daten oder MR-Testdaten abhängig von dem MR-Signal. Dazu kann das MR-Signal insbesondere mittels einer oder mehrerer Antennen oder Empfangsspulen der Signalerfassungsvorrichtung detektiert werden und mittels einer Empfangselektronik der Signalerfassungsvorrichtung in die MR-Testdaten umgewandelt werden, wobei die Empfangselektronik insbesondere einen Analog-zu-Digital-Wandler, ADC (englisch: "analog-to-digital-converter") beinhaltet. Dazu kann die Erfassungselektronik, insbesondere der ADC, beispielsweise aktiviert werden, während der Auslesegradient geschaltet wird und/oder nachdem der Auslesegradient geschaltet wurde.

Der Sollverlauf der Amplitude des Auslesegradienten entspricht dem theoretisch zu erwartenden zeitlichen Verlauf der Amplitude des Auslesegradienten bei idealen Bedingungen, also wenn keinerlei Störungen, wie etwa Wirbelströme oder dergleichen, vorliegen. Der Sollverlauf kann beispielsweise durch einen zeitlichen Verlauf des Stroms und/oder eines Steuersignals zur Ansteuerung der Gradientenspulenvorrichtung zum Schalten des Auslesegradienten gegeben sein beziehungsweise umgekehrt.

Insbesondere wird der Auslesegradient gemäß dem vorgegebenen Sollverlauf geschaltet oder abhängig von dem vorgegebenen Sollverlauf geschaltet.

Die Störgröße ist insbesondere eine Funktion der Zeit und kann auch als Störfunktion bezeichnet werden. Die Störgröße kann direkt der Abweichung des zeitlichen Verlaufs der Amplitude von dem vorgegebenen Sollverlauf entsprechen. Alternativ kann die Abweichung des zeitlichen Verlaufs der Amplitude von dem Sollverlauf eindeutig aus der Störgröße und gegebenenfalls weiteren bekannten Informationen berechnet werden.

Die Störgröße ist zum Beispiel unabhängig von dem Auslesegradienten und dem Sollverlauf. Dies hat den Vorteil, dass die einmal bestimmte oder berechnete Störgröße auch zur Berechnung einer Abweichung eines weiteren Auslesegradienten, Schichtselektionsgradienten oder weiteren Gradienten, von einem entsprechenden weiteren Sollverlauf bestimmt werden kann. Das Bestimmen der Störgröße kann also als eine Art der Störkalibrierung verstanden werden. Die Störgröße quantifiziert dabei den Einfluss von Störeffekten, wie etwa Wirbelströmen, auf die Erzeugung des Auslesegradienten und dessen tatsächliche Gradiententrajektorie. Die Störgröße quantifiziert aber auch den Einfluss der Störeffekte auf andere Gradiententrajektorien. Die Störgröße kann daher mit Vorteil einmalig bestimmt und dann zur weiteren Verwendung gespeichert werden.

Indem sowohl die erste Schicht als auch die zweite Schicht angeregt werden bevor der Auslesegradient geschaltet wird und das MR-Signal dementsprechend nicht aus der gesamten ersten Schicht und nicht aus der gesamten zweiten Schicht, sondern lediglich aus dem Schnittbereich emittiert wird, repräsentiert die Störgröße die Störeinflüsse in dem Schnittbereich und nicht die über die erste oder zweite Schicht gemittelten Störeinflüsse. Dadurch lässt sich also eine ortsaufgelöste Vermessung des Gradientenfelds und damit der Störgröße erreichen, die nicht nur auf eine Auflösung in einer Schichtselektionsrichtung beschränkt ist, sondern auch in einer weiteren Richtung. In der Folge lässt sich die Störgröße also mit einer erhöhten räumlichen Auflösung und dementsprechend genauer quantifizieren.

Gemäß zumindest einer Ausführungsform des Verfahrens wird die Störgröße als eine von dem Sollverlauf unabhängige Größe berechnet.

Die Störgröße wird also beispielsweise als zeitabhängige Funktion $e(t)$ berechnet, wobei $e(t)$ weder von dem zeitlichen Verlauf des Auslesegradienten noch von dem Sollverlauf abhängt, sondern lediglich von den Störeinflüssen selbst. Dies kann insbesondere erreicht werden, indem eine entsprechende Modellbeschreibung für die Störeinflüsse gewählt wird und mit den Messungen, also insbesondere den MR-Testdaten, die basierend auf dem erfassten MR-Signal berechnet werden, abgeglichen wird. Da die physikalischen Zusammenhänge wie ein Wirbelstrom oder eine sonstige Störung den Auslesegradienten beeinflussen kann an sich bekannt sind, kann bei Kenntnis des Sollverlaufs aus den gemessenen MR-Testdaten also die unabhängige Störgröße e(t) berechnet werden.

Die Störgröße kann dann gespeichert werden, beispielsweise auf einem Speichermedium des MRT-Systems, und zur weiteren Verwendung, insbesondere bei einem auf das Verfahren zur Vermessung des Gradientenfeldes folgenden Verfahren zur Magnetresonanzbildgebung, verwendet werden. Die Störgröße kann dabei insbesondere im Rahmen der eingangs erwähnten Wirbelstromkompensation und/oder beim Gridding berücksichtigt werden, um Artefakte zu vermeiden.

Die Unabhängigkeit der Störgröße von dem Sollverlauf hat insbesondere den Vorteil, dass bei der MR-Bildgebung dann beliebige andere Gradienten mit anderen Sollverläufen verwendet werden können, die dennoch mithilfe der Störgröße korrigiert werden können.

Gemäß zumindest einer Ausführungsform wird die erste Schicht angeregt, indem ein erster HF-Impuls in den Bildgebungsbereich emittiert wird und ein erster Schichtselektionsgradient wenigstens zum Teil gleichzeitig mit dem ersten HF-Impuls geschaltet wird.

HF steht dabei für Hochfrequenz und wird hier und im Folgenden mit der im Kontext der MR-Bildgebung üblicherweise verwendeten Bedeutung verwendet. Die Frequenz von HF-Impulsen liegt in der Regel in der Größenordnung der Larmorfrequenz der anzuregenden Kernspins, also je nach Größe des Grundmagnetfelds beispielsweise im Bereich von 10 MHz bis hin zu mehreren 100 MHz.

Dass der erste Schichtselektionsgradient wenigstens zum Teil gleichzeitig mit dem ersten HF-Impuls geschaltet wird, kann insbesondere derart verstanden werden, dass der erste HF-Impuls und der erste Schichtselektionsgradient einander zeitlich überlappen. Beispielsweise kann ein Zeitraum, während dem der erste HF-Impuls emittiert wird, vollständig innerhalb eines Zeitraums liegen, in dem der erste Schichtselektionsgradient geschaltet wird.

Gemäß zumindest einer Ausführungsform wird die zweite Schicht angeregt, indem ein zweiter HF-Impuls in den Bildgebungsbereich emittiert wird und ein zweiter Schichtselektionsgradient wenigstens zum Teil gleichzeitig mit dem zweiten HF-Impuls geschaltet wird.

Der erste und der zweite Schichtselektionsgradient zeigen dabei in unterschiedliche Richtungen, sodass sich die erste und die zweite Schicht entsprechend in dem Testobjekt schneiden.

Gemäß zumindest einer Ausführungsform liegt ein aus dem ersten HF-Impuls resultierender erster Flipwinkel in dem Intervall [60°, 120°] beispielsweise in dem Intervall [80°, 100°]. Beispielsweise ist der erste Flipwinkel gleich 90° oder näherungsweise gleich 90°.

Mit anderen Worten kann der erste HF-Impuls als Anregungsimpuls aufgefasst werden, der dementsprechend zur Präzession der Kernspins führt.

Sowohl das Signal eines Spinechos als auch das Signal eines stimulierten Echos wird hinsichtlich des ersten Flipwinkels maximal, wenn dieser gleich 90° ist. Das Signal verschwindet dagegen beispielsweise bei einem ersten Flipwinkel von 0°. Dementsprechend sind die genannten Intervalle mit einem vorteilhafterweise besonders großen Signal verbunden.

Gemäß zumindest einer Ausführungsform wird eine weitere erste Schicht in dem Testobjekt angeregt, insbesondere indem ein weiterer erster HF-Impuls in dem Bildgebungsbereich emittiert wird und ein weiterer erster Schichtselektionsgradient wenigstens zum Teil gleichzeitig mit dem weiteren ersten HF-Puls geschaltet wird. Nach der Anregung der weiteren ersten Schicht wird eine weitere zweite Schicht in dem Testobjekt angeregt, insbesondere indem ein weiterer zweiter HF-Impuls in den Bildgebungsbereich emittiert wird und ein weiterer zweiter Schichtselektionsgradient wenigstens zum Teil gleichzeitig mit dem weiteren zweiten HF-Impuls geschaltet wird. Die weitere zweite Schicht schneidet die weitere erste Schicht dabei innerhalb des Testobjekts in einem weiteren Schnittbereich. Nach der Anregung der weiteren zweiten Schicht wird abhängig von dem Sollverlauf ein weiterer Auslesegradient geschaltet und ein aus dem weiteren Schnittbereich emittiertes weiteres MR-Signal erfasst. Die Störgröße wird abhängig von dem MR-Signal und dem weiteren MR-Signal berechnet, insbesondere mittels der Recheneinheit.

Bezüglich des Schaltens des weiteren ersten Schichtselektionsgradienten und weiteren zweiten Schichtselektionsgradienten sowie des weiteren Auslesegradienten, bezüglich des Emittierens des weiteren ersten HF-Impulses und des weiteren zweiten HF-Impulses und bezüglich des Erfassens des weiteren MR-Signals wird auf die obigen Ausführungen zum ersten Schichtselektionsgradienten, zweiten Schichtselektionsgradienten, ersten HF-Impuls, zweiten HF-Impuls, Auslesegradienten und MR-Signal verwiesen. Diese lassen sich dementsprechend analog übertragen, insbesondere was die Verwendung der Gradientenspulenanordnung, der HF-Sendespulenvorrichtung und der Signalerfassungsvorrichtung betrifft.

Die Anregung der ersten weiteren Schicht und der zweiten weiteren Schicht und die entsprechende Erfassung des weiteren MR-Signals kann zeitlich dem Anregen der ersten Schicht und der zweiten Schicht beziehungsweise dem Erfassen des MR-Signals vorgelagert oder nachgelagert sein. Die Parameter zur Messung sind vorzugsweise identisch. Insbesondere sind die eingesetzten Flipwinkel möglichst der HF-Impulse sowie die Form der Schichtselektionsgradienten möglichst identisch.

Insbesondere ist der vorgegebene Sollverlauf sowohl ein Sollverlauf für den Auslesegradienten als auch für den weiteren Auslesegradienten. Mit anderen Worten, bei idealen Bedingungen oder nominell ist die Form des Auslesegradienten identisch zur Form des weiteren Auslesegradienten.

Insbesondere wird der weitere Auslesegradient gemäß dem vorgegebenen Sollverlauf geschaltet oder abhängig von dem vorgegebenen Sollverlauf geschaltet.

In manchen Ausführungsformen ist die erste weitere Schicht verschieden von der ersten Schicht und verschieden von der zweiten Schicht und die zweite weitere Schicht ist verschieden von der ersten Schicht und der zweiten Schicht. In manchen Ausführungsformen ist die erste Schicht gleich der ersten weiteren Schicht und die zweite Schicht ist von der zweiten weiteren Schicht verschieden. In weiteren Ausführungsformen ist die erste Schicht von der ersten weiteren Schicht verschieden und die zweite Schicht ist gleich der zweiten weiteren Schicht.

In einer bevorzugten Ausführungsform ist die erste Schicht gleich der ersten weiteren Schicht und die zweite Schicht ist parallel zur zweiten weiteren Schicht. Besonders bevorzugt ist die erste Schicht dabei senkrecht zur zweiten Schicht.

In einer weiteren bevorzugten Ausführungsform ist die erste Schicht parallel zur ersten weiteren Schicht und die zweite Schicht ist identisch zur zweiten weiteren Schicht. Besonders bevorzugt ist die erste Schicht dabei senkrecht zur zweiten Schicht.

Indem das weitere MR-Signal neben dem MR-Signal zur Berechnung der Störgröße berücksichtigt wird, können räumliche Variationen der Störeinflüsse extrahiert werden, insbesondere durch einen Phasenvergleich des MR-Signals mit dem weiteren MR-Signal.

Gemäß zumindest einer Ausführungsform wird die Störgröße abhängig von einer Phasendifferenz zwischen dem MR-Signal und dem weiteren MR-Signal berechnet.

Gemäß zumindest einer Ausführungsform wird die Störgröße als zeitabhängige Funktion e(t) basierend auf den Zusammenhang

$$\dot{\phi}(t)/(2\,\pi\,d\,\gamma) = G_s(t) - \int_0^t e(\tau)\,\dot{G}_s(\tau)\,d\tau, \qquad (1)$$

berechnet, wobei t die Zeit, $G_s$ den Sollverlauf, $\dot{G}_s$ die erste zeitliche Ableitung des Sollverlaufs, $\dot{\phi}$ die erste zeitliche Ableitung der Phasendifferenz, $\gamma$ das gyromagnetische Verhältnis und d einen räumlichen Abstand zwischen dem Schnittbereich und dem weiteren Schnittbereich bezeichnet.

In bevorzugten Ausführungsformen, in denen die erste Schicht und die erste weitere Schicht identisch sind und die zweite Schicht parallel zur zweiten weiteren Schicht ist, entspricht d dem räumlichen Abstand zwischen der zweiten Schicht und der zweiten weiteren Schicht. In bevorzugten Ausführungsformen, in denen die zweite und die zweite weitere Schicht identisch sind und die erste Schicht parallel zur ersten weiteren Schicht ist, entspricht d dem räumlichen Abstand zwischen der ersten Schicht und der ersten weiteren Schicht.

Um die Störgröße basierend auf dem obigen Zusammenhang zu berechnen, kann also insbesondere ein Fitverfahren oder eine sonstige Ausgleichsrechnung durchgeführt werden, um einen Funktion e(t) zu finden, die den obigen Zusammenhang bei gegebenem Sollverlauf und gemessenen Phasenunterschied am besten oder optimal wiedergibt.

Der Zusammenhang der Gleichung (1) rührt insbesondere daher, dass der Auslesegradient einerseits proportional zur zeitlichen Ableitung der Phasendifferenz ist und andererseits durch den Sollverlauf korrigiert um die Faltung der Störgröße mit der zeitlichen Ableitung des Sollverlaufs dargestellt werden kann.

Gemäß zumindest einer Ausführungsform wird für die Störgröße ein Ansatz gewählt, gemäß dem die Störgröße durch eine Vielzahl voneinander unabhängiger Parameter festgelegt wird und jeweilige Werte für die Vielzahl unabhängiger Parameter werden durch ein Fitverfahren berechnet.

Dass für die Störgröße der Ansatz gewählt wird, kann insbesondere derart verstanden werden, dass angenommen wird, dass sich die Störgröße näherungsweise durch einen mathematischen Ausdruck, insbesondere eine mathematische Funktion der Zeit, ausdrücken lässt. Der Ansatz kann beispielsweise beinhalten, dass die Störgröße als Exponentialfunktion oder als Summe solcher Exponentialfunktionen beschrieben wird. Beispielsweise kann der folgende Ansatz verwendet werden:

$$e(t) = \sum_{i=1}^N A_i e^{-t/\tau_i}. \qquad (2)$$

Dabei bezeichnen $A_i$ die Amplituden und $\tau_i$ die, insbesondere positiven, Zeitkonstanten einzelner Wirbelstrombeiträge zu der Störgröße e(t). Ferner ist N eine vorgegebene natürliche Zahl, insbesondere größer oder gleich 1.

Die Vielzahl der voneinander unabhängigen Parameter entspricht dann den $A_i$ und $\tau_i$. Durch das Fitverfahren werden insbesondere optimale Werte für die $A_i$ und die $\tau_i$ bestimmt, insbesondere indem die gemessene Phasendifferenz, der vorgegebene Sollverlauf und der Ansatz e(t) in den obigen Zusammenhang der Gleichung (1) gesetzt werden.

Das Fitverfahren kann es beispielsweise beinhalten, verschiedene Werte für die Vielzahl voneinander unabhängiger Parameter zu wählen und zu bewerten, wie gut der obige Zusammenhang erfüllt ist. Die Vielzahl unabhängiger Parameter wird dann variiert, um eine möglichst gute Übereinstimmung mit dem Zusammenhang zu erzielen.

Das Fitverfahren kann beispielsweise eine Ausgleichsrechnung, eine Parameterschätzung oder eine Regressionsrechnung beinhalten.

Gemäß zumindest einer Ausführungsform ist die weitere erste Schicht gleich der ersten Schicht und die weitere zweite Schicht ist parallel zu der zweiten Schicht, jedoch insbesondere nicht identisch zur zweiten Schicht.

Nimmt man beispielsweise an, dass die erste Schicht und die weitere erste Schicht einen bestimmten Bereich in X-Richtung definieren und die zweite und die weitere zweite Schicht jeweils verschiedene Bereiche in Y-Richtung senkrecht zur X-Richtung, so entspricht die Phasendifferenz in solchen Ausführungsformen einer Phasendifferenz in Y-Richtung bei konstantem X-Wert. Ist der Auslesegradient beispielsweise ein Gradient in X-Richtung, so kann die Störgröße beispielsweise einem Kreuzterm des X-Gradienten in Y-Richtung entsprechen. Ist der Auslesegradient ein Gradient in Y-Richtung, so kann die Störgröße gradientenartige Störungen in Y-Richtung darstellen.

Gemäß zumindest einer Ausführungsform ist die weitere zweite Schicht gleich der zweiten Schicht und die weitere erste Schicht ist parallel zur ersten Schicht, insbesondere aber nicht identisch zur ersten Schicht.

Gemäß zumindest einer Ausführungsform wird nach der Anregung der zweiten Schicht und vor dem Schalten des Auslesegradienten eine dritte Schicht in dem Testobjekt angeregt, wobei die dritte Schicht, die zweite Schicht und die erste Schicht einander in dem Schnittbereich schneiden.

Die dritte Schicht wird insbesondere angeregt, indem ein dritter HF-Impuls in den Bildgebungsbereich emittiert wird und ein dritter Schichtselektionsgradient wenigstens zum Teil gleichzeitig mit dem dritten HF-Impuls geschaltet wird.

Das MR-Signal geht in diesem Fall also insbesondere auf ein stimuliertes Echo zurück. Durch das Anregen der dritten Schicht wird der Schnittbereich weiter eingegrenzt, nämlich in drei Richtungen, die durch die erste, zweite und dritte Schicht gegeben sind.

In bevorzugten Ausführungsformen sind die erste, die zweite und die dritte Schicht jeweils zueinander paarweise senkrecht. In solchen Ausführungsformen ist der Schnittbereich also durch einen quaderförmigen oder würfelförmigen Volumenbereich gegeben. Dadurch lässt sich die Ortsauflösung der Vermessung des Gradientenfeldes beziehungsweise der Bestimmung der Störgröße weiter erhöhen.

Gemäß zumindest einer Ausführungsform wird nach der Anregung der weiteren zweiten Schicht und vor dem Schalten des weiteren Auslesegradienten eine weitere dritte Schicht in dem Testobjekt angeregt, wobei die weitere dritte Schicht, die weitere zweite Schicht und die weitere erste Schicht einander in dem Schnittbereich schneiden.

Gemäß zumindest einer Ausführungsform ist die dritte Schicht senkrecht zu der ersten Schicht und die dritte Schicht ist senkrecht zu der zweiten Schicht.

Gemäß zumindest einer Ausführungsform ist die weitere dritte Schicht parallel zur dritten Schicht.

Gemäß zumindest einer Ausführungsform liegt ein aus dem zweiten HF-Puls resultierender zweiter Flipwinkel in dem Intervall [60°, 120°], beispielsweise in dem Intervall [80°, 100°], oder der zweite Flipwinkel ist gleich 90°.

Ein aus dem dritten HF-Impuls resultierender dritter Flipwinkel liegt in dem Intervall [60°, 120°], beispielsweise in dem Intervall [80°, 100°], oder der dritte Flipwinkel ist gleich 90°.

Solche Ausführungsformen sind insbesondere vorteilhaft, wenn die dritte Schicht angeregt wird und beispielsweise die weitere dritte Schicht angeregt wird, es sich bei dem MR-Signal beziehungsweise dem weiteren MR-Signal also um ein auf ein stimuliertes Echo zurückgehendes Signal handelt.

Die maximale Amplitude des stimulierten Echos ist sowohl proportional zum Sinus des zweiten Flipwinkels als auch zum Sinus des dritten Flipwinkels. Die stärkste Resonanzantwort des stimulierten Echos ergibt sich also hinsichtlich des ersten und des zweiten Flipwinkels, wenn diese beide gleich 90° sind. Die bezeichneten Intervalle liefern ebenfalls noch gute Ergebnisse.

Es sei darauf hingewiesen, dass die maximale Amplitude des stimulierten Echos auch proportional zum Sinus des ersten Flipwinkels ist. Die optimale Resonanzantwort ergibt sich also insgesamt, wenn der erste, der zweite und der dritte Flipwinkel jeweils gleich 90° sind.

Gemäß zumindest einer Ausführungsform liegt der zweite Flipwinkel in dem Intervall [150°, 210°], beispielsweise in dem Intervall [170°, 190°], oder der zweite Flipwinkel ist gleich 180°.

Solche Ausführungsformen sind insbesondere vorteilhaft, wenn die dritte Schicht nicht angeregt wird und beispielsweise die weitere dritte Schicht nicht angeregt wird, das MR-Signal beziehungsweise das weitere MR-Signal also auf ein Spinecho zurückgeht.

Die maximale Amplitude des Spinechos ist proportional zum Sinus der Hälfte des zweiten Flipwinkels. Außerdem ist die maximale Amplitude des Spinechos proportional zum Sinus des ersten Flipwinkels. Demzufolge ist ein zweiter Flipwinkel von 180° optimal, insbesondere in Kombination mit einem ersten Flipwinkel von 90°.

Gemäß einem weiteren Aspekt der Erfindung wird auch ein Verfahren zur Magnetresonanztomographie, MRT, mittels eines MRT-Systems angegeben. Dabei wird ein Verfahren zur Vermessung eines Gradientenfelds in einem Bildgebungsbereich des MRT-Systems gemäß der Erfindung durchgeführt. Wenigstens ein MR-Bild, also insbesondere ein Ortsraumbild, wird, insbesondere mittels einer Recheneinheit des MRT-Systems, abhängig von der Störgröße erzeugt.

Beispielsweise werden mittels des MRT-Systems MR-Daten erzeugt, die ein Objekt, welches gleich dem Testobjekt sein kann oder von dem Testobjekt verschieden sein kann, in dem Bildgebungsbereich darstellen und das MR-Bild wird abhängig von den MR-Daten und der Störgröße erzeugt.

Die Erzeugung der MR-Daten kann dabei in einer bekannten Weise erfolgen. Die Störgröße kann dann beispielsweise bei der Bildrekonstruktion zur Bildkorrektur, beispielsweise zur Phasenkorrektur im Falle von EPI-Messungen, oder beim Re-Gridding der MR-Daten verwendet werden.

In solchen Ausführungsformen werden die MR-Daten also unabhängig von der Störgröße erzeugt und die Störgröße wird zusammen mit den MR-Daten erst zum Erzeugen des MR-Bildes berücksichtigt.

In alternativen Ausführungsformen werden mittels des MRT-Systems die MR-Daten erzeugt, wobei zum Erzeugen der MR-Daten wenigstens ein Gradientenimpuls abhängig von der Störgröße geschaltet wird, und das MR-Bild wird abhängig von den MR-Daten erzeugt.

In solchen Ausführungsformen wird die Störgröße also bereits beim Erzeugen des Gradientenimpulses, der beispielsweise ebenfalls ein Auslesegradient sein kann, berücksichtigt.

Beispielsweise kann ein weiterer Sollverlauf für den Gradientenimpuls abhängig von der Störgröße korrigiert werden und der wenigstens eine Gradientenimpuls kann abhängig von dem korrigierten Sollverlauf geschaltet werden.

Ferner ist es auch möglich, dass die Berücksichtigung der Störgröße beim Schalten des Gradientenimpulses mit der Berücksichtigung der Störgröße beim Erzeugen des MR-Bildes im Nachhinein kombiniert wird.

Gemäß einem weiteren Aspekt der Erfindung wird ein MRT-System angegeben. Das MRT-System weist einen Bildgebungsbereich auf, eine HF-Sendespulenanordnung und eine Gradientenspulenanordnung. Der Bildgebungsbereich ist von der HF-Sendespulenanordnung und der Gradientenspulenanordnung umgeben. Das MRT-System weist eine Signalerfassungsvorrichtung auf und wenigstens eine Steuereinheit, die dazu eingerichtet ist, die HF-Sendespulenanordnung und die Gradientenspulenanordnung anzusteuern, um eine erste Schicht in einem Testobjekt, das sich in dem Bildgebungsbereich befindet, anzuregen. Dabei ist die wenigstens eine Steuereinheit insbesondere dazu eingerichtet, die HF-Sendespulenanordnung anzusteuern, einen ersten HF-Impuls in den Bildgebungsbereich zu emittieren, und die Gradientenspulenanordnung anzusteuern, wenigstens zum Teil gleichzeitig mit dem ersten HF-Impuls ersten Schichtselektionsgradienten zu schalten, um die erste Schicht anzuregen. Die wenigstens eine Steuereinheit ist dazu eingerichtet, die HF-Sendespulenanordnung und die Gradientenspulenanordnung anzusteuern, um nach der Anregung der ersten Schicht eine zweite Schicht in dem Testobjekt anzuregen, wobei die zweite Schicht die erste Schicht, insbesondere innerhalb des Testobjekts, in einem Schnittbereich schneidet. Dabei ist die wenigstens eine Steuereinheit insbesondere dazu eingerichtet, die HF-Sendespulenanordnung anzusteuern, einen zweiten HF-Impuls in den Bildgebungsbereich zu emittieren und die Gradientenspulenanordnung anzusteuern, wenigstens zum Teil gleichzeitig mit dem zweiten HF-Impuls einen zweiten Schichtselektionsgradient zu schalten, um die zweite Schicht anzuregen. Die wenigstens eine Steuereinheit ist dazu eingerichtet, die Gradientenspulenanordnung anzusteuern, nach der Anregung der zweiten Schicht einen Auslesegradienten zu schalten und die Signalerfassungsvorrichtung anzusteuern, ein aus dem Schnittbereich emittiertes MR-Signal zu erfassen. Das MRT-System weist eine Recheneinheit auf, die dazu eingerichtet ist, abhängig von dem MR-Signal eine Störgröße zu berechnen, die eine Abweichung eines zeitlichen Verlaufs einer Amplitude des Auslesegradienten von einem vorgegebenen Sollverlauf bestimmt.

Die Signalerfassungsvorrichtung beinhaltet dabei insbesondere wenigstens eine Empfangsspule und eine Empfangselektronik, die beispielsweise einen ADC und/oder eine Empfangssteuereinheit aufweist. Die HF-Sendespulenanordnung weist insbesondere wenigstens eine Sendespule auf. Die wenigstens eine Empfangsspule kann dabei in machen Ausführungen teilweise oder vollständig mit der wenigstens einen Sendespule übereinstimmen.

Weitere Ausführungsformen des erfindungsgemäßen MRT-Systems folgen unmittelbar aus den verschiedenen Ausgestaltungen des erfindungsgemäßen Verfahrens und umgekehrt. Insbesondere lassen sich einzelne Merkmale und entsprechende Erläuterungen bezüglich der verschiedenen Ausführungsformen zu dem erfindungsgemäßen Verfahren analog auf entsprechende Ausführungsformen des erfindungsgemäßen MRT-Systems übertragen. Insbesondere ist das erfindungsgemäße MRT-System zum Durchführen eines erfindungsgemäßen Verfahrens ausgebildet oder programmiert. Insbesondere führt das erfindungsgemäße MRT-System das erfindungsgemäße Verfahren durch.

Gemäß einem weiteren Aspekt der Erfindung wird ein Computerprogramm mit Befehlen angegeben. Wenn die Befehle durch ein erfindungsgemäßes MRT-System ausgeführt werden, veranlassen die Befehle das MRT-System dazu, ein erfindungsgemäßes Verfahren zur Vermessung eines Gradientenfelds und/oder ein erfindungsgemäßes Verfahren zur MRT durchzuführen.

Gemäß einem weiteren Aspekt der Erfindung wird ein computerlesbares Speichermedium angegeben, welches ein erfindungsgemäßes Computerprogramm speichert.

Unter einer Recheneinheit kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen. Auch eine Steuereinheit kann daher eine Recheneinheit darstellen oder beinhalten oder Teil einer Recheneinheit sein.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere digitale Signalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SRAM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCRAM (englisch: "phase-change random access memory"), ausgestaltet sein.

Ist im Rahmen der vorliegenden Offenbarung die Rede davon, dass eine Komponente des erfindungsgemäßen MRT-Systems, insbesondere die Recheneinheit, die wenigstens eine Steuereinheit oder die Signalerfassungsvorrichtung des MRT-Systems, dazu eingerichtet, ausgebildet, ausgelegt, oder dergleichen ist, eine bestimmte Funktion auszuführen oder zu realisieren, eine bestimmte Wirkung zu erzielen oder einem bestimmten Zweck zu dienen, so kann dies derart verstanden werden, dass die Komponente, über die prinzipielle oder theoretische Verwendbarkeit oder Eignung der Komponente für diese Funktion, Wirkung oder diesen Zweck hinaus, durch eine entsprechende Anpassung, Programmierung, physische Ausgestaltung und so weiter konkret und tatsächlich dazu in der Lage ist, die Funktion auszuführen oder zu realisieren, die Wirkung zu erzielen oder dem Zweck zu dienen.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren gezeigten Merkmale und Merkmalskombinationen können nicht nur in der jeweils angegebenen Kombination, sondern auch in anderen Kombinationen von der Erfindung umfasst sein. Es können insbesondere auch Ausführungen und Merkmalskombinationen von der Erfindung umfasst sein, die nicht alle Merkmale eines ursprünglich formulierten Anspruchs aufweisen. Es können darüber hinaus Ausführungen und Merkmalskombinationen von der Erfindung umfasst, die über die in den Rückbezügen der Ansprüche dargelegten Merkmalskombinationen hinausgehen oder von diesen abweichen.

Die Erfindung wird im Folgenden anhand konkreter Ausführungsbeispiele und zugehöriger schematischer Zeichnungen näher erläutert. In den Figuren können gleiche oder funktionsgleiche Elemente mit denselben Bezugszeichen versehen sein. Die Beschreibung gleicher oder funktionsgleicher Elemente wird gegebenenfalls nicht notwendigerweise bezüglich verschiedener Figuren wiederholt.

In den Figuren zeigen

FIG 1     eine schematische Darstellung einer beispielhaften Ausführungsform eines erfindungsgemäßen MRT-Systems;

FIG 2     einen zeitlichen Verlauf einer Amplitude eines Gradienten sowie einen entsprechenden Sollverlauf;

FIG 3     schematisch ein MR-Impulsdiagramm gemäß einer beispielhaften Ausführungsform eines erfindungsgemäßen Verfahrens zur Vermessung eines Gradientenfelds;

FIG 4     schematisch angeregte Schichten in einem Testobjekt gemäß einer weiteren beispielhaften Ausführungsform eines erfindungsgemäßen Verfahrens zur Vermessung eines Gradientenfelds;

FIG 5     schematisch angeregte Schichten in einem Testobjekt gemäß einer weiteren beispielhaften Ausführungsform eines erfindungsgemäßen Verfahrens zur Vermessung eines Gradientenfelds;

FIG 6     schematisch angeregte Schichten in einem Testobjekt gemäß einer weiteren beispielhaften Ausführungsform eines erfindungsgemäßen Verfahrens zur Vermessung eines Gradientenfelds; und

FIG 7     schematisch ein MR-Impulsdiagramm gemäß einer weiteren beispielhaften Ausführungsform eines erfindungsgemäßen Verfahrens zur Vermessung eines Gradientenfelds.

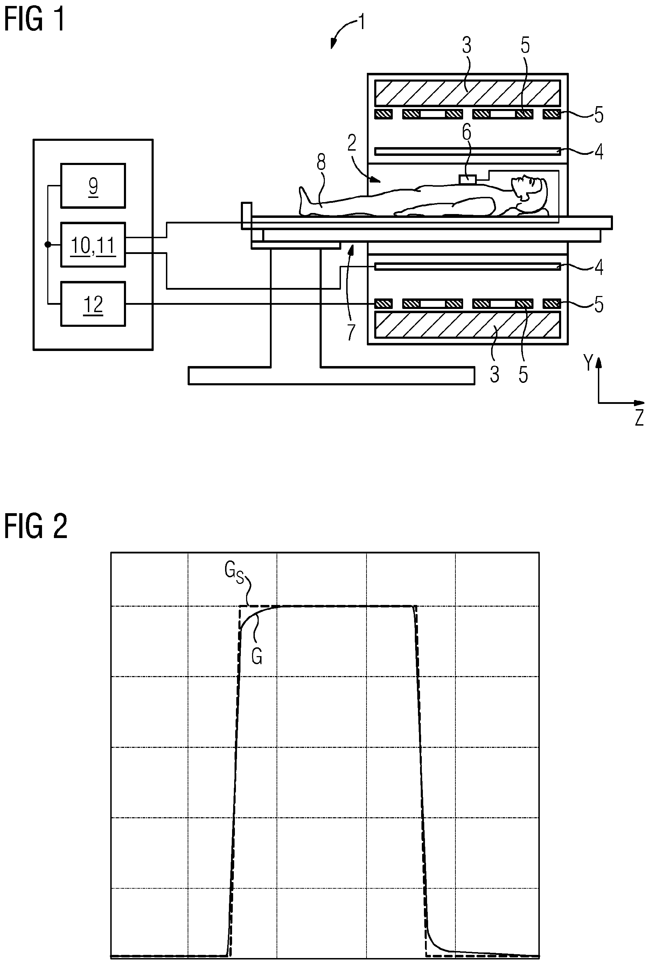

FIG 1 zeigt eine schematische Darstellung einer beispielhaften Ausführungsform eines erfindungsgemäßen MRT-Systems 1.

Das MRT-System 1 umfasst eine Magneteinheit mit einem Feldmagneten 3, der ein statisches Magnetfeld zur Ausrichtung von Kernspins eines Objekts 8, zum Beispiel eines Patienten, in einem Bildgebungsbereich erzeugt. Der Bildgebungsbereich ist durch ein äußerst homogenes statisches Magnetfeld gekennzeichnet, wobei sich die Homogenität insbesondere auf die Magnetfeldstärke beziehungsweise deren Amplitude bezieht. Der Bildgebungsbereich befindet sich in einem Patiententunnel 2, der sich in einer Längsrichtung Z durch die Magneteinheit erstreckt. Der Feldmagnet 3 kann beispielsweise ein supraleitender Magnet sein, der Magnetfelder mit einer magnetischen Flussdichte von bis zu 3 T oder mehr erzeugen kann. Für geringere Feldstärken können jedoch auch Permanentmagnete oder Elektromagnete mit normalleitenden Spulen verwendet werden. Ein Patiententisch 7 kann innerhalb des Patiententunnels 2 beweglich sein.

Weiterhin umfasst die Magneteinheit eine Gradientenspulenanordnung 5 mit mehreren Gradientenspulen, die dazu dienen, dem statischen Magnetfeld Gradientenfelder, also ortsabhängige Magnetfelder, in den drei Raumrichtungen zur räumlichen Differenzierung der abgetasteten Bildbereiche im Bildgebungsbereich zu überlagern. Die Gradientenspulen der Gradientenspulenanordnung 5 können zum Beispiel als Spulen aus normalleitenden Drähten ausgebildet sein, die zum Beispiel zueinander orthogonale Felder oder Feldgradienten im Bildgebungsbereich erzeugen können.

Die Magneteinheit umfasst eine Sendespulenanordnung, die beispielsweise eine Körperspule 4 als Sendeantenne umfassen kann, die dazu ausgebildet ist, ein Hochfrequenzsignal in den Bildgebungsbereich abzustrahlen. Die Körperspule 4 kann daher als HF-Sendespulenanordnung des MRT-Systems 1 verstanden werden oder als Teil der HF-Sendespulenanordnung. Die Körperspule 4 kann in einigen Ausführungsformen auch dazu verwendet werden, resonante MR-Signale zu empfangen, die von dem Objekt 8 ausgesendet werden. In diesem Fall kann die Körperspule 4 auch als Teil einer Signalerfassungsvorrichtung des MRT-Systems 1 betrachtet werden. Optional umfasst die Signalerfassungsvorrichtung eine lokale Spule 6, die in unmittelbarer Nähe des Objekts 8, zum Beispiel an dem Objekt 8 oder in dem Patiententisch 7, angeordnet sein kann. Die lokale Spule 6 kann alternativ oder zusätzlich zur Körperspule 4 als Empfangsspule beziehungsweise Empfangsantenne dienen.

Das MRT-System 1 umfasst auch ein Steuer- und Rechensystem. Das Steuer- und Rechensystem kann eine Empfangssteuereinheit 10 umfassen, die als Teil der Signalerfassungsvorrichtung angesehen werden kann und mit der Körperspule 4 und/oder der lokalen Spule 6 verbunden ist. In Abhängigkeit von den erfassten MR-Signalen kann die Empfangssteuereinheit 10, die einen Analog-Digital-Wandler, ADC (englisch: "analog-to-digital converter") umfassen kann, entsprechende MR-Daten, insbesondere im k-Raum, erzeugen. Eine Recheneinheit 9 des Steuer- und Rechensystems kann die MR-Daten auswerten und zum Beispiel eine Bildrekonstruktion durchführen.

Das Steuer- und Rechensystem umfasst eine Sendesteuereinheit 11, die mit der Körperspule 4 verbunden ist und diese zur Erzeugung von HF-Impulsen, wie Anregungsimpulsen und/oder Refokussierungsimpulsen, steuert. Das Steuer- und Rechensystem umfasst eine Gradientensteuereinheit 12, die mit der Gradientenspulenanordnung 5 verbunden ist und diese steuert, um Schichtselektionsgradienten, Gradienten für die Frequenz- und/oder Phasencodierung und/oder Auslesegradienten zu schalten.

Es wird darauf hingewiesen, dass die beschriebene Struktur des Steuer- und Rechensystems nur ein nicht begrenztes Beispiel darstellt. Die verschiedenen erforderlichen Aufgaben und Funktionen können auch anders und/oder auf verschiedene Steuereinheiten und/oder andere Recheneinheiten verteilt sein.

Das MRT-System 1 ist insbesondere in der Lage, ein Verfahren zur MRT gemäß der Erfindung durchzuführen, welches insbesondere ein erfindungsgemäßes Verfahren zur Vermessung eines Gradientenfelds in dem Bildgebungsbereich beinhaltet.

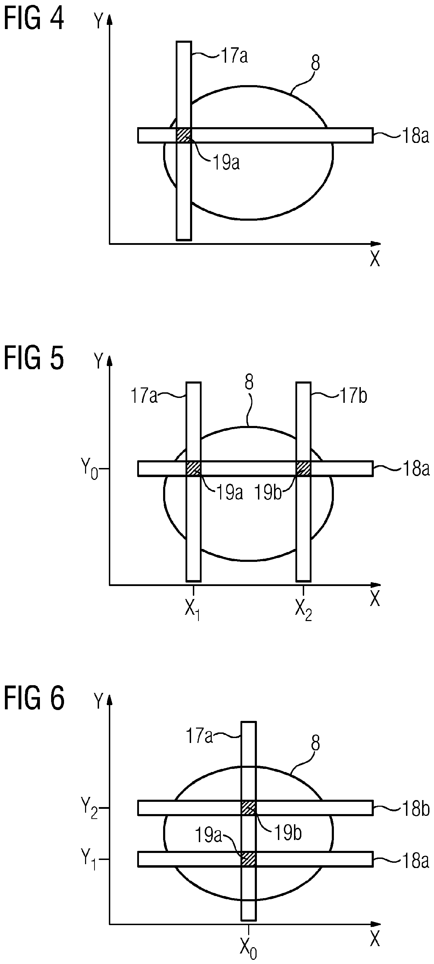

Dazu steuern die Gradientensteuereinheit 12 und die Sendesteuereinheit 11 die Gradientenspulenanordnung 5 beziehungsweise die Körperspule 4 an, um zunächst eine erste Schicht 17a und danach eine zweite Schicht 18a in dem Objekt anzuregen, wobei die zweite Schicht 18a die erste Schicht 17a in einem Schnittbereich 19a schneidet, wie in FIG 4 dargestellt. Im Beispiel der FIG 4 ist die erste Schicht senkrecht zur X-Richtung und damit parallel zur Y-Z-Ebene und die zweite Schicht 18a ist senkrecht zur Y-Richtung und damit parallel zur X-Z-Ebene. Es sind jedoch auch andere Orientierungen möglich, insbesondere auch solche, bei denen die erste Schicht 17a und die zweite Schicht 18a nicht senkrecht aufeinander stehen. Stehen die erste Schicht 17a und die zweite Schicht 18a jedoch senkrecht aufeinander, so schneiden sich die beiden Schichten 17a, 18a, in einem Volumenbereich mit der Form eines Quaders oder einer Säule mit rechteckigem oder quadratischem Querschnitt, die sich parallel zur Z-Richtung erstreckt. Der Schnittbereich 19a kann dieser Säule entsprechen oder, in Ausführungsformen, in denen noch eine dritte Schicht angeregt wird, die beispielsweise senkrecht zur ersten Schicht 17a und zur zweiten Schicht 18a steht, einem Teil der Säule.

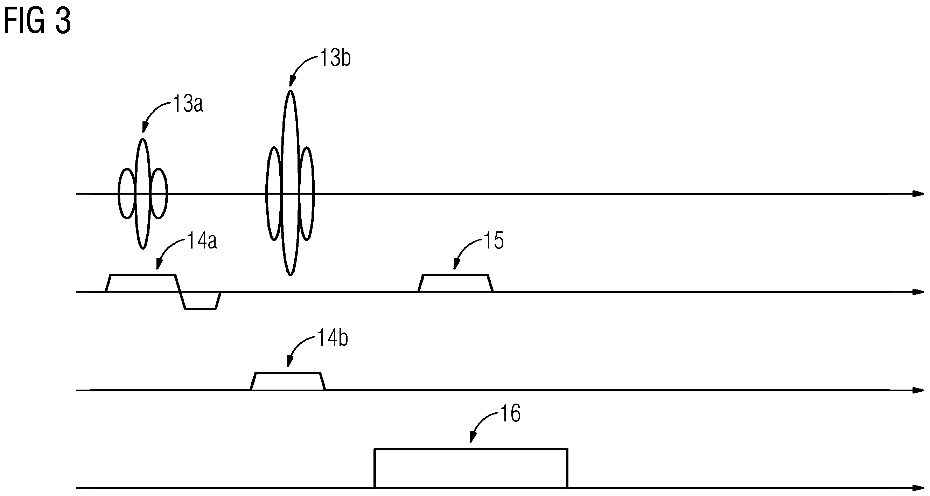

Zum Anregen der ersten Schicht 17a kann die Sendesteuereinheit 11 beispielsweise die Körperspule 4 ansteuern, einen ersten HF-Impuls 13a, insbesondere einen Anregungsimpuls mit einem Flipwinkel von 90°, zu emittieren, und die Gradientensteuereinheit 12 kann die Gradientenspulenanordnung 5 ansteuern, im Wesentlichen zeitgleich einen ersten Schichtselektionsgradienten 14a zu schalten, wie es im Impulsdiagramm der FIG 3 schematisch dargestellt ist. Im vorliegenden Beispiel wird der erste Schichtselektionsgradient 14a in X-Richtung geschaltet. Zum Anregen der zweiten Schicht 18a kann die Sendesteuereinheit 11 dann die Körperspule 4 ansteuern, einen zweiten HF-Impuls 13b, insbesondere einen Refokussierungsimpuls mit einem Flipwinkel von 180°, zu emittieren, und die Gradientensteuereinheit 12 kann die Gradientenspulenanordnung 5 ansteuern, im Wesentlichen zeitgleich dazu einen zweiten Schichtselektionsgradienten 14b zu schalten, wie ebenfalls in FIG 3 gezeigt. Im vorliegenden Beispiel wird der zweite Schichtselektionsgradient 14b in Y-Richtung geschaltet.

Nach der Anregung der ersten Schicht 17a und der zweiten Schicht, steuert die Gradientsteuereinheit 12 die Gradientenspulenanordnung 5 an, einen Auslesegradienten 15 zu schalten, beispielsweise in X-Richtung, um ein MR-Signal eines Spin-Echos aus dem ersten Schnittbereich 19a zu detektieren. Hierzu wird der ADC der Empfangssteuereinheit 10 in einem Auslesefenster 16 aktiviert. Der Auslesegradient 15 kann zeitlich beispielsweise innerhalb des Auslesefensters 16 liegen oder diesem vorgelagert sein. Der gezeigte Auslesegradient 15 kann auch nur teilweise während des Auslesefensters ADC ausgespielt werden oder vor diesem liegen, um die nach einem Gradientenimpuls bestehenden Störeffekte zu untersuchen.

Die Recheneinheit 9 kann dann basierend auf dem MR-Signal beziehungsweise entsprechend erzeugten MR-Daten eine Störgröße berechnen, die eine Abweichung eines zeitlichen Verlaufs einer Amplitude des Auslesegradienten 15 von einem vorgegebenen Sollverlauf bestimmt.

In FIG 2 ist schematisch der zeitliche Verlauf des Auslesegradienten 15 als Kurve G gezeigt und der entsprechende Sollverlauf als Kurve $G_s$. Im Allgemeinen kann der Zusammenhang zwischen G und $G_s$ wie folgt angesetzt werden

$$G(t) = G_s(t) - \frac{dG_s(t)}{dt} * e(t), \qquad (3)$$

wobei e(t) die Störgröße bezeichnet und der Operator * eine Faltung darstellt. Die Störgröße selbst kann wie folgt angesetzt werden

$$e(t) = \sum_{i=1}^{N} A_i e^{-t/\tau_i}. \qquad (4)$$

Darin bezeichnen $A_i$ die Amplituden und $\tau_i$ die Zeitkonstanten der einzelnen Störbeiträge, beispielsweise WirbelstromBeiträge. Für die Ermittlung der Amplituden und Zeitkonstanten können verschiedene Verfahren verwendet werden.

Um die Amplituden und Zeitkonstanten zu bestimmen, wird neben der oben bezüglich FIG 3 und FIG 4 beschriebenen Messung am ersten Schnittbereich 19a beispielsweise an mindestens einer weiteren Position eine Messung durchgeführt, wie in FIG 5 beispielhaft dargestellt. Hierzu wird, analog wie oben beschrieben, beispielsweise eine weitere erste Schicht 17b angeregt, die insbesondere parallel zu der ersten Schicht 17a ist. Beispielsweise können die erste Schicht 17a an einer X-Position X1 und die weitere erste Schicht 17b an einer X-Position X2 zentriert sein. Dann wird erneut die zweite Schicht 18a angeregt, sodass sich die weitere erste Schicht 17b und die zweite Schicht 18a in einem zweiten Schnittbereich 19b schneiden. Es wird dann erneut der Auslesegradient 15 geschaltet, um ein weiteres MR-Signal aus dem zweiten Schnittbereich 19b zu messen.

Alternativ wird, wie in FIG 6 gezeigt, die erste Schicht 17a erneut angeregt und danach eine weitere zweite Schicht 18b, die insbesondere parallel zu der zweiten Schicht 18a ist. Beispielsweise können die zweite Schicht 18a an einer Y-Position Y1 und die weitere zweite Schicht 18b an einer Y-Position Y2 zentriert sein. Hier schneiden sich dann die erste Schicht 17a und die weitere zweite Schicht 18b in dem zweiten Schnittbereich 19b. Es wird auch hier erneut der Auslesegradient 15 geschaltet, um ein weiteres MR-Signal aus dem zweiten Schnittbereich 19b zu messen.

Aus dem MR-Signal und dem weiteren MR-Signal kann dann eine Phasendifferenz $\phi(t)$ bestimmt werden und aus deren erster zeitlicher Ableitung die Gradiententrajektorie G(t) bestimmt

$$G(t) = \frac{1}{2\pi \, d \, \gamma} \frac{d\phi}{dt}, \qquad (5)$$

wobei $\gamma$ das gyromagnetische Verhältnis ist, d im Beispiel der FIG 5 dem Abstand X2-X1 der ersten Schicht 17a von der weiteren ersten Schicht 17b entspricht und im Beispiel der FIG 6 dem Abstand Y2-Y1 der zweiten Schicht 18a von der weiteren zweiten Schicht 18b.

Durch einen Fit der Messwerte gemäß Gleichung (5) an den Zusammenhang der Gleichung (3) können die Amplituden und Zeitkonstanten der Störgröße e(t) bestimmt werden.

Durch das erfindungsgemäße Verfahren kann also der zeitliche Verlauf von Gradientenfeldern und Feldstörungen höherer räumlicher Ordnung vermessen werden, die beispielsweise durch Wirbelströme verursacht werden. Dabei werden auch Kurzzeit-Effekte, zum Beispiel Wirbelströme mit sehr kurzen Zeitkonstanten, erfasst. Ein besonderer Anwendungszweck ist die Korrektur von Gradiententrajektorien beim Gridding. Dazu können Störungen höherer räumlicher Ordnung lokal durch gradientenartige Störungen angenähert werden.

Optional können zusätzliche Referenzmessungen ausgeführt werden, bei denen an den jeweiligen Schichtpositionen ohne Ausspielung des Auslesegradienten 15 gemessen wird. Diese Daten aus den Referenzmessungen können beispielsweise von den Daten der Messung mit dem Auslesegradienten 15 subtrahiert werden, zum Beispiel Sample für Sample, um nicht im Fokus stehende Effekte wie Drifteffekte des B0-Feldes oder Einflüsse von sogenannten konkomitierenden Feldern zu unterdrücken. Zudem sei erwähnt, dass zur Erhöhung des Signal-zu-Rausch-Verhältnisses eine bestimmte Zahl von Wiederholungen der ansonsten gleichen Messungen ausgespielt werden kann, woraufhin dann die entsprechenden Daten gemittelt werden.

Die insbesondere in FIG 4, FIG 5 und FIG 6 gezeigten Achsen sind exemplarisch zu sehen, andere mögliche Kombinationen sind ebenso möglich. Ebenso ist es möglich, noch weitere Gradientenpulse zum Beispiel zum sogenannten Spoiling von unerwünschten Signalen zu verwenden, zum Beispiel zum Unterdrücken von Signalen aufgrund des freien Induktionszerfalls, FID (englisch: "free induction decay").

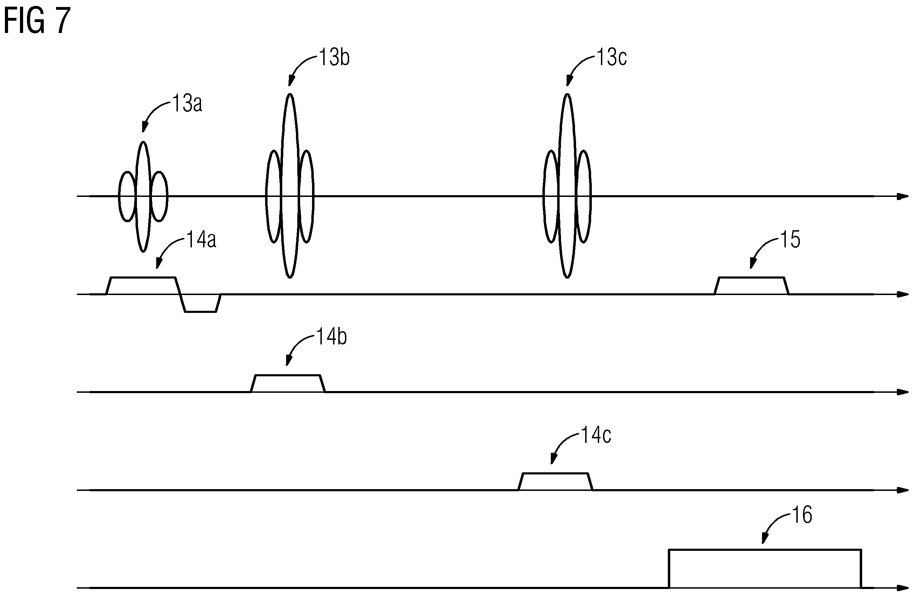

Für eine Weiterbildung des Verfahrens ist ein Impulsdiagramm in FIG 7 gezeigt. Im Vergleich zu dem bezüglich FIG 3 erläuterten Verfahren wird mindestens ein dritter HF-Impuls 13c mit gleichzeitigem dritten Schichtselektionsgradienten 14c verwendet, wobei insbesondere alle verwendeten Schichtselektionsgradienten 14a, 14b, 14c in verschiedene Richtungen zeigen, vorzugsweise zueinander orthogonal sind.

Das Verfahren mit zwei HF-Impulsen 13a, 13b nutzt das entstehende Spinecho, das Verfahren mit drei HF-Impulsen 13a, 13b, 13c nutzt das entstehende stimulierte Echo. Während der Flipwinkel des zweiten HF-Impulses 13b im ersten Fall beispielsweise gleich 180° und der des ersten HF-Impulses 13a gleich 90° sind, um ein maximales Spin-Echo zu erzeugen, sind im zweiten Fall die Flipwinkel aller drei HF-Impulse 13a, 13b, 13c beispielsweise gleich 90°, um ein maximales stimuliertes Echo zu erzeugen.

Durch die sich schneidenden, zueinander vorzugsweise orthogonalen, angeregten Schichten stammt das erzeugte MR-Signal aus deren Schnittbereich 19a, 19b. Bei dem Verfahren mit nur zwei HF-Impulsen 13a, 13b stammt das Signal aus einer Säule, die in der dritten Koordinate nicht begrenzt ist. Die Kantenlängen der begrenzten Seiten der Säule sind durch die Schichtdicken gegeben, die aus den zwei HF-Impulsen 13a, 13b resultieren. Bei dem Verfahren mit drei HF-Impulsen 13a, 13b, 13c stammt das Signal aus einem Voxel, dessen Kantenlängen durch die Dicken der durch die drei HF-Impulse 13a, 13b, 13c angeregten Schichten gegeben ist.

Wie beim Verfahren mit zwei HF-Impulsen 13a, 13b ist es auch beim Verfahren mit drei HF-Impulsen 13a, 13b, 13c möglich, weitere Gradientenpulse zum Beispiel zum Spoiling von unerwünschten Signalen zu verwenden, zum Beispiel zum Unterdrücken eines FID Signals. Bei dem Verfahren mit drei HF-Impulsen 13a, 13b, 13c kann durch Spoiling gegebenenfalls auch das Spinecho-Signal unterdrückt werden.

In beiden Fällen werden insbesondere Messungen an verschiedenen Positionen durchgeführt, sodass der Schnittbereich 19a, 19b, aus dem das Signal stammt an verschiedenen Orten liegt. Die Auswahl der Schichtposition wird insbesondere durch die Frequenz der entsprechenden HF-Impulse bestimmt. Beispielsweise werden Messungen an zwei Positionen durchgeführt. Für die Messung des zeitlichen Verlaufs des Auslesegradienten 15, zum Beispiel eines X-Gradienten, sind die Schnittbereich 19a, 19b in die jeweilige Richtung versetzt, also zum Beispiel in X-Richtung, wie in FIG 5 dargestellt. Als Variation ist es auch möglich, die Messung bei mehr als zwei Positionen, beispielsweise in X-Richtung, durchzuführen, und die gemessenen Feldeffekte in lineare und höhere Ordnungen aufzuteilen.

Im Unterschied zu bekannten Verfahren bietet die Erfindung also die Möglichkeit, den zeitlichen Verlauf eines Gradienten in einer Richtung bei einer festen anderen Koordinate, im Falle der FIG 5 zum Beispiel bei Y0, zu messen. Dies ist insbesondere vorteilhaft, wenn Feldstörungen höherer Ordnung vorliegen, die aber lokal durch eine gradientenartige Störung angenähert werden können.

Zudem bieten Ausführungsformen der Erfindung die Möglichkeit, die Dynamik der erzeugten Felder in einer anderen Richtung als der des erzeugenden Gradienten zu bestimmen, wie in FIG 7 dargestellt. Aus den Messungen bei den beiden Schnittbereichen 19a, 19b kann beispielsweise der sogenannte Kreuzterm des X-Gradienten in Y-Richtung bestimmt werden, also der dynamische Feldverlauf in Y-Richtung, der durch den X-Gradienten erzeugt wird. Hier ist es auch möglich, diese Messungen bei mehreren X- oder weiteren Y-Positionen durchzuführen, um die gemessenen Feldverläufe in lineare Kreuzterme und Feldverläufe höherer räumlicher Ordnung aufzuteilen.

Durch Anwendung des Verfahrens mit drei HF-Impulsen 13a, 13b, 13c kann die zuvor beschriebene räumliche Eingrenzung zur Untersuchung eines Gradienten in einer weiteren Koordinate eingegrenzt werden. Zum Beispiel ist es in solchen Ausführungsformen möglich, den Verlauf und die Störeffekte eines X-Gradienten bei Positionen Y0 und Z0 zu bestimmen, wenn die Achsen der Schichtselektionsgradienten 14a, 14b, 14c entsprechend gewählt werden.

Das Verfahren mit drei HF-Impulsen 13a, 13b, 13c ist auch geeignet, um dynamische Feldverteilungen höherer räumlicher Ordnung zu bestimmen. Dabei können Messungen an verschiedenen Voxeln durchgeführt werden und aus den gemessenen Phasenverläufen die räumliche Verteilung der Feldeffekte eines auf einer Achse ausgespielten Gradienten gemessen werden. Damit können dreidimensionale Feldverteilungen, und mithin auch Wirbelströme höherer räumlicher Ordnung bestimmt werden. Eine Analyse der Feldverteilungen höherer räumlicher Ordnungen kann beispielsweise basierend auf der Entwicklung der gemessenen Felder in Kugelflächenfunktionen, die einen Satz orthonormaler Basisfunktionen darstellen, erfolgen. Es ist damit zum Beispiel möglich, aus Messungen an neun verschiedenen Positionen, Feldverteilungen höherer räumlicher Ordnung bis zur zweiten Ordnung zu bestimmen. Mit Messungen an 16 Positionen lassen sich Verteilungen bis zur dritten Ordnung bestimmen und so weiter.

Das erfindungsgemäße Verfahren kann in verschiedenen Ausführungsformen bei der Kalibration des MRT-Systems 1 durchgeführt werden, zum Beispiel als Teil eines sogenannten Tune-up-Prozesses. Die ermittelten Informationen und Daten, insbesondere die Störgröße e(t) können dann für bildgebende Messungen beziehungsweise zu deren Rekonstruktion genutzt werden. Alternativ oder zusätzlich ist es auch möglich, Ausführungsformen des Verfahrens jeweils direkt vor einer bildgebenden Messung mit dem jeweiligen Patienten auszuführen. Dann sind auch weitere Parameter bekannt, wie die Positionierung der zu messenden Schichten. Daher kann die Kalibrationsmessung dann darauf ausgerichtet werden, sodass zum Beispiel der Gradientenverlauf eines Auslesegradienten direkt an der Position einer zu messenden Schicht vermessen wird.

Die durch das beschriebene Verfahren gewonnenen Informationen und Daten lassen sich auf vielfältige Weise nutzen. Als Beispiele sei das Gridding genannt. Der gemessene Gradientenverlauf kann verwendet werden, um die gemessenen Daten im k-Raum zu korrigieren. In entsprechenden Ausführungsformen der Erfindung kann der Gradientenverlauf an Positionen gemessen werden, die in einer oder zwei Koordinaten eingeschränkt sind. Dadurch kann die Gridding-Korrektur ortsabhängig durchgeführt werden, zum Beispiel ausgerichtet auf die jeweils gemessene Schicht. Bei transversalen Schichten, also mit Schichtselektion in Z-Richtung, mit Auslesegradient in X-Richtung kann etwa der tatsächliche X-Gradient als Funktion der Z-Position vermessen werden. Damit kann dann die Gridding-Korrektur schichtabhängig erfolgen. Ebenso kann auch eine Gridding-Korrektur in andere Richtungen als die Auslese-richtung, zum Beispiel in Phasenkodier- oder Schichtselektionsrichtung, ausgeführt werden.

In anderen Anwendungsfällen kann eine schichtabhängige und/oder positionsabhängige Wirbelstromkorrektur durchgeführt werden. Die Parameter der Wirbelstrom-Korrektur durch Pre-Emphasis können unter Verwendung der ermittelten Störgröße auch schicht- und/oder positionsabhängig gewählt werden.

Im Allgemeinen können Ausführungsformen der Erfindung zur Bestimmung von Wirbelströmen höherer Ordnung und von Kreuztermen genutzt werden, wobei auch kürzeste Zeitkonstanten vermessen werden können. Die ermittelten Kreuzterme können dann zum Beispiel auch durch Pre-Emphasis angewendet werden. Die Daten können auch zu weiteren Bildkorrekturen, zum Beispiel für Phasenkorrekturen bei EPI-Messungen, verwendet werden.

Durch verschiedene Ausführungsformen der Erfindung kann gegebenenfalls Messzeit eingespart werden, da keine komplette Segmentierung nötig ist. Es können beispielsweise lediglich Messungen an den relevanten Positionen durchgeführt werden, beispielsweise an 16 Voxel für eine dreidimensionale Bestimmung der Feldverläufe in dritter räumlicher Ordnung. Die vorgeschlagenen Messungen lassen sich in verschiedenen Ausführungsformen auch als Navigator- oder Pre-Scan-Messungen in bildgebende Sequenzen integrieren. Ausführungsformen der Erfindung erfordern außerdem keine zusätzliche Sensorik, wie Feldsonden oder dergleichen.

**Patentansprüche**

1. Verfahren zur Vermessung eines Gradientenfeldes in einem Bildgebungsbereich (2) eines MRT-Systems (1), wobei eine erste Schicht (17a) in einem Testobjekt (8), das sich in dem Bildgebungsbereich (2) befindet, angeregt wird, **dadurch gekennzeichnet, dass**

    - nach der Anregung der ersten Schicht (17a) eine zweite Schicht (18a) in dem Testobjekt (8) angeregt wird, wobei die zweite Schicht (18a) die erste Schicht (17a) in einem Schnittbereich (19a) schneidet;
    - nach der Anregung der zweiten Schicht (18a) ein Auslesegradient (15) geschaltet wird und ein aus dem Schnittbereich (19a) emittiertes MR-Signal erfasst wird;
    - abhängig von dem MR-Signal eine Störgröße berechnet wird, die eine Abweichung eines zeitlichen Verlaufs einer Amplitude des Auslesegradienten (15) von einem vorgegebenen Sollverlauf für den Auslesegradienten (15) bestimmt.

**2.** Verfahren nach Anspruch 1, wobei die Störgröße als eine von dem Sollverlauf unabhängige Größe berechnet wird.

**3.** Verfahren nach einem der vorhergehenden Ansprüche, wobei die erste Schicht (17a) angeregt wird, indem ein erster HF-Impuls (13a, 13b, 13c) in den Bildgebungsbereich (2) emittiert wird und ein erster Schichtselektionsgradient (14a, 14b, 14c) wenigstens zum Teil gleichzeitig mit dem ersten HF-Impuls (13a, 13b, 13c) geschaltet wird, wobei ein aus dem ersten HF-Impuls resultierender erster Flipwinkel insbesondere in dem Intervall [60°, 120°] liegt, beispielsweise in dem Intervall [80°, 100°], oder wobei der erste Flipwinkel gleich 90° ist.

**4.** Verfahren nach einem der vorhergehenden Ansprüche, wobei

- eine weitere erste Schicht (17b) in dem Testobjekt (8) angeregt wird;
- nach der Anregung der weiteren ersten Schicht (17b) eine weitere zweite Schicht (18b) in dem Testobjekt (8) angeregt wird, wobei die weitere zweite Schicht (18b) die weitere erste Schicht (17b) in einem weiteren Schnittbereich (19b) schneidet;
- nach der Anregung der weiteren zweiten Schicht (18b) abhängig von dem Sollverlauf ein weiterer Auslesegradient (15) geschaltet wird und ein aus dem weiteren Schnittbereich (19b) emittiertes weiteres MR-Signal erfasst wird;
- die Störgröße abhängig von dem MR-Signal und dem weiteren MR-Signal berechnet wird.

**5.** Verfahren nach Anspruch 4, wobei die Störgröße abhängig von einer Phasendifferenz zwischen dem MR-Signal und dem weiteren MR-Signal berechnet wird.

**6.** Verfahren nach Anspruch 5, wobei die Störgröße als zeitabhängige Funktion e(t) basierend auf dem Zusammenhang

$$\dot{\phi}(t)/(2\,\pi\,d\,\gamma) \;=\; G_s(t) \;-\; \int_0^t e(\tau)\;\dot{G}_s(\tau)\;d\tau$$

berechnet wird, wobei t die Zeit bezeichnet, $G_s$ den Sollverlauf bezeichnet, $\dot{G}_s$ die erste zeitliche Ableitung des Sollverlaufs bezeichnet, $\dot{\phi}$ die erste zeitliche Ableitung der Phasendifferenz bezeichnet, $\gamma$ das gyromagnetische Verhältnis bezeichnet und d einen räumlichen Abstand zwischen dem Schnittbereich und dem weiteren Schnittbereich bezeichnet.

**7.** Verfahren nach Anspruch 6, wobei für die Störgröße ein Ansatz gewählt wird, gemäß dem die Störgröße durch eine Vielzahl voneinander unabhängiger Parameter festgelegt wird und jeweilige Werte für die Vielzahl voneinander unabhängiger Parameter durch ein Fitverfahren berechnet werden.

**8.** Verfahren nach einem der Ansprüche 4 bis 7, wobei

- die weitere erste Schicht (17b) gleich der ersten Schicht (17a) ist und die weitere zweite Schicht (18a) parallel zu der zweiten Schicht (18a) ist; oder
- die weitere zweite Schicht (18b) gleich der zweiten Schicht (18a) ist und die weitere erste Schicht (17b) parallel zu der ersten Schicht (17a) ist.

**9.** Verfahren nach einem der Ansprüche 4 bis 8, wobei nach der Anregung der zweiten Schicht (18a) und vor dem Schalten des Auslesegradienten (15) eine dritte Schicht in dem Testobjekt (8) angeregt wird, wobei die dritte Schicht, die zweite Schicht (18a) und die erste Schicht (17a) einander in dem Schnittbereich (19a) schneiden.

**10.** Verfahren nach Anspruch 9, wobei die dritte Schicht senkrecht zu der ersten Schicht (17a) und senkrecht zu der zweiten Schicht (18a) ist.

**11.** Verfahren nach einem der Ansprüche 9 oder 10, wobei

- die zweite Schicht (18a) angeregt wird, indem ein zweiter HF-Impuls (13a, 13b, 13c) in den Bildgebungsbereich (2) emittiert wird und ein zweiter Schichtselektionsgradient (14a, 14b, 14c) wenigstens zum Teil gleichzeitig mit dem zweiten HF-Impuls (13a, 13b, 13c) geschaltet wird, wobei ein aus dem zweiten HF-Impuls resultierender zweiter Flipwinkel insbesondere in dem Intervall [60°, 120°] liegt, beispielsweise in dem Intervall [80°, 100°], oder wobei der zweite Flipwinkel gleich 90° ist; und
- die dritte Schicht angeregt wird, indem ein dritter HF-Impuls (13a, 13b, 13c) in den Bildgebungsbereich (2) emittiert wird und ein dritter Schichtselektionsgradient (14a, 14b, 14c) wenigstens zum Teil gleichzeitig mit dem dritten HF-Impuls (13a, 13b, 13c) geschaltet wird, wobei ein aus dem dritten HF-Impuls resultierender dritter Flipwinkel insbesondere in dem Intervall [60°, 120°] liegt, beispielsweise in dem Intervall [80°, 100°], oder wobei der dritte Flipwinkel gleich 90° ist.

**12.** Verfahren nach einem der Ansprüche 1 bis 8, wobei die zweite Schicht (18a) angeregt wird, indem ein zweiter HF-Impuls (13a, 13b, 13c) in den Bildgebungsbereich (2) emittiert wird und ein zweiter Schichtselektionsgradient (14a, 14b, 14c) wenigstens zum Teil gleichzeitig mit dem zweiten HF-Impuls (13a, 13b, 13c) geschaltet wird, wobei ein aus dem zweiten HF-Impuls resultierender zweiter Flipwinkel insbesondere in dem Intervall [150°, 210°] liegt, beispielsweise in dem Intervall [170°, 190°], oder wobei der zweite Flipwinkel gleich 180° ist.

**13.** Verfahren zur Magnetresonanztomographie, MRT, mittels eines MRT-Systems (1) wobei

- ein Verfahren zur Vermessung eines Gradientenfelds in einem Bildgebungsbereich (2) des MRT-Systems (1) gemäß einem der vorhergehenden Ansprüche durchgeführt wird; und
- wenigstens ein MR-Bild abhängig von der Störgröße erzeugt wird.

**14.** Verfahren nach Anspruch 13, wobei

- mittels des MRT-Systems (1) MR-Daten erzeugt werden, die ein Objekt (8) in dem Bildgebungsbereich (2) darstellen und das MR-Bild abhängig von den MR-Daten und der Störgröße erzeugt wird;
oder
- mittels des MRT-Systems (1) MR-Daten erzeugt werden, wobei zum Erzeugen der MR-Daten wenigstens ein Gradientenimpuls abhängig von der Störgröße geschaltet wird, und das MR-Bild abhängig von den MR-Daten erzeugt wird.

**15.** MRT-System (1) mit einem Bildgebungsbereich (2), der von einer HF-Sendespulenanordnung (4) und einer Gradientenspulenanordnung (5) umgeben ist, das MRT-System (1) aufweisend eine Signalerfassungsvorrichtung (4, 6, 10) und wenigstens eine Steuereinheit (11, 12), die dazu eingerichtet ist, die HF-Sendespulenanordnung (4) und die Gradientenspulenanordnung (5) anzusteuern, um eine erste Schicht (17a) in einem Testobjekt (8), das sich in dem Bildgebungsbereich (2) befindet, anzuregen,
**dadurch gekennzeichnet, dass**

- die wenigstens eine Steuereinheit (11, 12) dazu eingerichtet ist, die HF-Sendespulenanordnung (4) und die Gradientenspulenanordnung (5) anzusteuern, um nach der Anregung der ersten Schicht (17a) eine zweite Schicht (18a) in dem Testobjekt (8) anzuregen, wobei die zweite Schicht (18a) die erste Schicht (17a) in einem Schnittbereich (19a) schneidet;
- die wenigstens eine Steuereinheit (11, 12) dazu eingerichtet ist, die Gradientenspulenanordnung (5) anzusteuern, nach der Anregung der zweiten Schicht (18a) einen Auslesegradienten (15) zu schalten und die Signalerfassungsvorrichtung (4, 6, 10) anzusteuern, ein aus dem Schnittbereich (19a) emittiertes MR-Signal zu erfassen;
- das MRT-System (1) eine Recheneinheit (9) aufweist, die dazu eingerichtet ist, abhängig von dem MR-Signal eine Störgröße zu berechnen, die eine Abweichung eines zeitlichen Verlaufs einer Amplitude des Auslesegradienten (15) von einem vorgegebenen Sollverlauf bestimmt.


**Geänderte Patentansprüche gemäss Regel 137(2) EPÜ.**

**1.** Verfahren zur Vermessung eines Gradientenfeldes in einem Bildgebungsbereich (2) eines MRT-Systems (1), wobei eine erste Schicht (17a) in einem Testobjekt (8), das sich in dem Bildgebungsbereich (2) befindet, angeregt wird, **dadurch gekennzeichnet, dass**

- nach der Anregung der ersten Schicht (17a) eine zweite Schicht (18a) in dem Testobjekt (8) angeregt wird, wobei die zweite Schicht (18a) die erste Schicht (17a) in einem Schnittbereich (19a) schneidet;
- nach der Anregung der zweiten Schicht (18a) ein Auslesegradient (15) geschaltet wird und ein aus dem Schnittbereich (19a) emittiertes MR-Signal erfasst wird;
- abhängig von dem MR-Signal eine Störgröße berechnet wird, die eine Abweichung eines zeitlichen Verlaufs einer Amplitude des Auslesegradienten (15) von einem vorgegebenen Sollverlauf für den Auslesegradienten (15) bestimmt,

**dadurch gekennzeichnet, dass** nach der Anregung der zweiten Schicht (18a) und vor dem Schalten des Auslesegradienten (15) eine dritte Schicht in dem Testobjekt angeregt wird, wobei die dritte Schicht, die zweite Schicht (18a) und die erste Schicht (17a) einander in dem Schnittbereich schneiden.

2. Verfahren nach Anspruch 1, wobei die Störgröße als eine von dem Sollverlauf unabhängige Größe berechnet wird.

3. Verfahren nach einem der vorhergehenden Ansprüche, wobei die erste Schicht (17a) angeregt wird, indem ein erster HF-Impuls (13a, 13b, 13c) in den Bildgebungsbereich (2) emittiert wird und ein erster Schichtselektionsgradient (14a, 14b, 14c) wenigstens zum Teil gleichzeitig mit dem ersten HF-Impuls (13a, 13b, 13c) geschaltet wird, wobei ein aus dem ersten HF-Impuls resultierender erster Flipwinkel insbesondere in dem Intervall [60°, 120°] liegt, beispielsweise in dem Intervall [80°, 100°], oder wobei der erste Flipwinkel gleich 90° ist.

4. Verfahren nach einem der vorhergehenden Ansprüche, wobei

   - eine weitere erste Schicht (17b) in dem Testobjekt (8) angeregt wird;
   - nach der Anregung der weiteren ersten Schicht (17b) eine weitere zweite Schicht (18b) in dem Testobjekt (8) angeregt wird, wobei die weitere zweite Schicht (18b) die weitere erste Schicht (17b) in einem weiteren Schnittbereich (19b) schneidet;
   - nach der Anregung der weiteren zweiten Schicht (18b) abhängig von dem Sollverlauf ein weiterer Auslesegradient (15) geschaltet wird und ein aus dem weiteren Schnittbereich (19b) emittiertes weiteres MR-Signal erfasst wird;
   - die Störgröße abhängig von dem MR-Signal und dem weiteren MR-Signal berechnet wird.

5. Verfahren nach Anspruch 4, wobei die Störgröße abhängig von einer Phasendifferenz zwischen dem MR-Signal und dem weiteren MR-Signal berechnet wird.

6. Verfahren nach Anspruch 5, wobei die Störgröße als zeitabhängige Funktion e(t) basierend auf dem Zusammenhang

$$\dot{\phi}(t)/(2\,\pi\,d\,\gamma) \;=\; G_s(t) \;-\; \int_0^t e(\tau)\;\dot{G}_s(\tau)\;d\tau$$

berechnet wird, wobei t die Zeit bezeichnet, $G_s$ den Sollverlauf bezeichnet, $\dot{G}_s$ die erste zeitliche Ableitung des Sollverlaufs bezeichnet, $\dot{\phi}$ die erste zeitliche Ableitung der Phasendifferenz bezeichnet, $\gamma$ das gyromagnetische Verhältnis bezeichnet und d einen räumlichen Abstand zwischen dem Schnittbereich und dem weiteren Schnittbereich bezeichnet.

7. Verfahren nach Anspruch 6, wobei für die Störgröße ein Ansatz gewählt wird, gemäß dem die Störgröße durch eine Vielzahl voneinander unabhängiger Parameter festgelegt wird und jeweilige Werte für die Vielzahl voneinander unabhängiger Parameter durch ein Fitverfahren berechnet werden.

8. Verfahren nach einem der Ansprüche 4 bis 7, wobei

   - die weitere erste Schicht (17b) gleich der ersten Schicht (17a) ist und die weitere zweite Schicht (18a) parallel zu der zweiten Schicht (18a) ist; oder
   - die weitere zweite Schicht (18b) gleich der zweiten Schicht (18a) ist und die weitere erste Schicht (17b) parallel zu der ersten Schicht (17a) ist.

9. Verfahren nach einem der vorangehenden Ansprüche, wobei die dritte Schicht senkrecht zu der ersten Schicht (17a) und senkrecht zu der zweiten Schicht (18a) ist.

10. Verfahren nach einem der vorangehenden Ansprüche, wobei

- die zweite Schicht (18a) angeregt wird, indem ein zweiter HF-Impuls (13a, 13b, 13c) in den Bildgebungsbereich (2) emittiert wird und ein zweiter Schichtselektionsgradient (14a, 14b, 14c) wenigstens zum Teil gleichzeitig mit dem zweiten HF-Impuls (13a, 13b, 13c) geschaltet wird, wobei ein aus dem zweiten HF-Impuls resultierender zweiter Flipwinkel insbesondere in dem Intervall [60°, 120°] liegt, beispielsweise in dem Intervall [80°, 100°], oder wobei der zweite Flipwinkel gleich 90° ist; und

- die dritte Schicht angeregt wird, indem ein dritter HF-Impuls (13a, 13b, 13c) in den Bildgebungsbereich (2) emittiert wird und ein dritter Schichtselektionsgradient (14a, 14b, 14c) wenigstens zum Teil gleichzeitig mit dem dritten HF-Impuls (13a, 13b, 13c) geschaltet wird, wobei ein aus dem dritten HF-Impuls resultierender dritter Flipwinkel insbesondere in dem Intervall [60°, 120°] liegt, beispielsweise in dem Intervall [80°, 100°], oder wobei der dritte Flipwinkel gleich 90° ist.

11. Verfahren nach einem der Ansprüche 1 bis 8, wobei die zweite Schicht (18a) angeregt wird, indem ein zweiter HF-Impuls (13a, 13b, 13c) in den Bildgebungsbereich (2) emittiert wird und ein zweiter Schichtselektionsgradient (14a, 14b, 14c) wenigstens zum Teil gleichzeitig mit dem zweiten HF-Impuls (13a, 13b, 13c) geschaltet wird, wobei ein aus dem zweiten HF-Impuls resultierender zweiter Flipwinkel insbesondere in dem Intervall [150°, 210°] liegt, beispielsweise in dem Intervall [170°, 190°], oder wobei der zweite Flipwinkel gleich 180° ist.

12. Verfahren zur Magnetresonanztomographie, MRT, mittels eines MRT-Systems (1) wobei

- ein Verfahren zur Vermessung eines Gradientenfelds in einem Bildgebungsbereich (2) des MRT-Systems (1) gemäß einem der vorhergehenden Ansprüche durchgeführt wird; und
- wenigstens ein MR-Bild abhängig von der Störgröße erzeugt wird.

13. Verfahren nach Anspruch 12, wobei

- mittels des MRT-Systems (1) MR-Daten erzeugt werden, die ein Objekt (8) in dem Bildgebungsbereich (2) darstellen und das MR-Bild abhängig von den MR-Daten und der Störgröße erzeugt wird;
oder
- mittels des MRT-Systems (1) MR-Daten erzeugt werden, wobei zum Erzeugen der MR-Daten wenigstens ein Gradientenimpuls abhängig von der Störgröße geschaltet wird, und das MR-Bild abhängig von den MR-Daten erzeugt wird.

14. MRT-System (1) mit einem Bildgebungsbereich (2), der von einer HF-Sendespulenanordnung (4) und einer Gradientenspulenanordnung (5) umgeben ist, das MRT-System (1) aufweisend eine Signalerfassungsvorrichtung (4, 6, 10) und wenigstens eine Steuereinheit (11, 12), die dazu eingerichtet ist, die HF-Sendespulenanordnung (4) und die Gradientenspulenanordnung (5) anzusteuern, um eine erste Schicht (17a) in einem Testobjekt (8), das sich in dem Bildgebungsbereich (2) befindet, anzuregen, wobei

- die wenigstens eine Steuereinheit (11, 12) dazu eingerichtet ist, die HF-Sendespulenanordnung (4) und die Gradientenspulenanordnung (5) anzusteuern, um nach der Anregung der ersten Schicht (17a) eine zweite Schicht (18a) in dem Testobjekt (8) anzuregen, wobei die zweite Schicht (18a) die erste Schicht (17a) in einem Schnittbereich (19a) schneidet;
- die wenigstens eine Steuereinheit (11, 12) dazu eingerichtet ist, die Gradientenspulenanordnung (5) anzusteuern, nach der Anregung der zweiten Schicht (18a) einen Auslesegradienten (15) zu schalten und die Signalerfassungsvorrichtung (4, 6, 10) anzusteuern, ein aus dem Schnittbereich (19a) emittiertes MR-Signal zu erfassen;
- das MRT-System (1) eine Recheneinheit (9) aufweist, die dazu eingerichtet ist, abhängig von dem MR-Signal eine Störgrö-ße zu berechnen, die eine Abweichung eines zeitlichen Verlaufs einer Amplitude des Auslesegradienten (15) von einem vorgegebenen Sollverlauf bestimmt;

**dadurch gekennzeichnet, dass** die wenigstens eine Steuereinheit (11, 12) dazu eingerichtet ist, die HF-Sendespulenanordnung (4) und die Gradientenspulenanordnung (5) anzusteuern, um nach der Anregung der zweiten Schicht (18a) und vor dem Schalten des Auslesegradienten (15) eine dritte Schicht in dem Testobjekt anzuregen, wobei die dritte Schicht, die zweite Schicht (18a) und die erste Schicht (17a) einander in dem Schnittbereich schneiden.

FIG 1

FIG 2

FIG 3

EP 4 253 976 A1

FIG 4

FIG 5

FIG 6

FIG 7

EP 4 253 976 A1

Europäisches
Patentamt

European
Patent Office

Office européen
des brevets

**EUROPÄISCHER RECHERCHENBERICHT**

Nummer der Anmeldung

EP 22 16 4891

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2013/002232 A1 (HITACHI MEDICAL CORP [JP]; HIRAI KOSUKE [JP] ET AL.) 3. Januar 2013 (2013-01-03) * Seiten 4-13 der maschinell generierten Übersetzung * * Abbildungen 3, 5, 6 * ----- | 1-15 | INV. G01R33/24 G01R33/565 |

RECHERCHIERTE SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 31. August 2022 | Streif, Jörg Ulrich |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

................................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 16 4891

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31−08−2022

| Im Recherchenbericht angeführtes Patentdokument | Datum der Veröffentlichung | Mitglied(er) der Patentfamilie | Datum der Veröffentlichung |
|---|---|---|---|
| WO 2013002232 A1 | 03−01−2013 | JP WO2013002232 A1<br>WO 2013002232 A1 | 23−02−2015<br>03−01−2013 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5451877 A
- US 20160091582 A1